# DEMANDE DE BREVET EUROPEEN

(11) **EP 1 715 516 A1**
(43) Date de publication de la demande: **25.10.2006**
(21) Numéro de dépôt: 06290578.1
(22) Date de dépôt: 07.04.2006
(51) Int. Cl.: H01L 21/762, H01L 21/306

(54) **Traitement de plaques de semi-conducteur**

(30) Priorité: 15.04.2005 FR 0503781
(71) Demandeur: S.O.I.Tec Silicon on Insulator Technologies, 38190 Bernin (FR)
(72) Inventeur: Coletti, Stéphane, 38660 Saint Vincent de Mercuze (FR); Duquennoy-Pont, Véronique, 38000 Grenoble (FR)
(74) Mandataire: Desormiere, Pierre-Louis

(57) **Abrégé**

Procédé de traitement d'une plaque comprenant au moins une couche superficielle en matériau semi-conducteur, la surface de ladite couche superficielle ayant subit une étape de polissage mécano-chimique suivie d'une étape de nettoyage RCA. Le procédé comprend, après l'étape de polissage et avant l'étape de nettoyage RCA, une étape de nettoyage intermédiaire de la surface de la couche superficielle en matériau semi-conducteur avec une solution de SC1 dans des conditions de concentration et de température permettant de réduire l'apparition de défauts dans la couche superficielle (courbe A) par rapport à une même couche superficielle n'ayant pas subi ladite étape de nettoyage intermédiaire (courbe B).

## Description

### Domaine technique et art antérieur

La présente invention concerne le traitement ou nettoyage des surfaces de plaques, également dénommées "wafers", qui se présentent sous la forme d'une tranche mince présentant en surface une couche en matériau semi-conducteur (ex. silicium (Si) ou silicium-germanium (SiGe)) appelée "couche utile" et qui constitue un support à partir duquel peuvent être réalisés des composants en grande quantité (ex. cellules de circuits intégrés ou dispositifs discrets).

Une des techniques connues pour fabriquer de telles plaques est la technologie Smart Cut™ par laquelle on obtient par exemple une plaque de SOI ("Silicon On Insulator" : silicium sur isolant). Un exemple de mise en oeuvre de la technologie Smart Cut™ appliqué à la réalisation de plaques de SOI est notamment décrit dans le document US 5 374 564 ou dans l'article de A.J. Auberton-Hervé et al. intitulé "Why can Smart-Cut Change the future of microelectronics ?", Int. Journal of High Speed Electronics and Systems, Vol.10, No1, 2000, p.131-146. D'une manière générale, la technologie Smart Cut™ consiste à implanter des espèces atomiques sous une face d'une plaque de semi-conducteur (ex. Si ou SiGe), dans une zone d'implantation, à mettre en contact intime la face de la plaque soumise à l'implantation avec un substrat support, et à réaliser un clivage de la plaque au niveau de la zone d'implantation pour transférer la partie de la plaque située entre la surface soumise à l'implantation et la zone d'implantation sur le substrat support.

On obtient ainsi une structure (ex. structure SOI) avec une couche transférée sur une face du substrat support. Après clivage et transfert, on réalise un traitement de la surface de la couche transférée pour enlever partiellement l'épaisseur de la couche implantée et réduire la rugosité de cette surface de clivage. Des exemples de tels traitements sont notamment décrits dans les documents US 2004/115905 et WO/0115215. Typiquement, le traitement comprend une étape de polissage suivie d'une étape de nettoyage réalisée avant une éventuelle dernière étape d'oxydation sacrificielle, et/ou de traitement thermique de lissage. L'étape de polissage permet de réduire la rugosité à un niveau inférieure à 2,5 angströms (Å) RMS (ex. 2 Å RMS) pour des surfaces de balayage point par point ("scan area", réalisé par exemple au microscope à force atomique) de 2*2 microns.

Plus précisément, dans un premier temps, le polissage comprend une étape de polissage mécano-chimique mettant en oeuvre un plateau de polissage associé à une solution de polissage contenant un agent apte à attaquer chimiquement la surface de la couche et des particules abrasives aptes à attaquer mécaniquement ladite surface, et une étape de rinçage en général avec de l'eau dé-ionisée (EDI). Dans un second temps, on réalise une étape de nettoyage consistant à traiter les plaques avec des solutions de nettoyage.

Pour le nettoyage de surfaces de plaques comprenant une couche superficielle en matériau semi-conducteur, il est ainsi connu d'utiliser un traitement standard dit "RCA" qui comprend:
- une première étape de nettoyage avec une solution de SC1 (acronyme anglo-saxon de "Standard Clean 1") (ou APM acronyme anglo-saxon de "Ammonium-hydroxide Peroxide Mixture") ; contenant de l'hydroxyde d'ammonium (NH₄OH), du peroxyde d'hydrogène (H₂O₂) et de l'eau dé-ionisée (H₂O).
- une deuxième étape de nettoyage avec une solution de SC2 (acronyme anglo-saxon de "Standard Clean 2") (ou HPM acronyme anglo-saxon de "Hydrochloric Peroxide Mixture"); contenant de l'acide chlorhydrique (HCl) et du peroxyde d'hydrogène (H₂O₂) et de l'eau dé-ionisée.

La première solution de SC1, généralement utilisée entre 50 et 80°C, est destinée principalement à retirer les particules isolées en surface de la plaque et les particules enterrées au voisinage de la surface, ainsi qu'à rendre la surface hydrophile.

La deuxième solution de SC2, généralement utilisée entre 70 et 90°C, est destinée principalement à retirer des contaminations métalliques qui ont pu se déposer en surface de la plaquette, en formant notamment des chlorures.

Pour des structures minces, c'est-à-dire des structures (ex. structures SOI) comprenant une couche utile semi-conductrice d'épaisseur inférieure à environ 1000 Å, on a observé des densités de défauts "HF" sur les produits finaux (i.e. après l'oxydation sacrificielle finale) qui dépassent les valeurs limites acceptables. On appelle défauts "HF" les défauts dans la couche active semi-conductrice de la structure SOI qui s'étendent à partir de la surface de cette couche jusque dans l'oxyde enterré et dont la présence peut être révélée par une auréole de décoration après traitement de la structure SOI dans un bain d'acide fluorhydrique. La densité de défauts HF observée pour certaines plaques peut aller jusqu'à 15 défauts/cm² alors que la valeur limite préconisée est typiquement de l'ordre de 0,5/cm², voire inférieure à 0,1/cm².

Les défauts HF sont considérés comme des défauts "destructeurs" pour les plaques parce qu'ils les rendent non viables (qualité non acceptable) pour des traitements ultérieurs en particulier pour la formation de composants.

### Résumé de l'invention

L'invention a pour but de proposer une solution technique pour les couches en matériau semi-conducteur ayant subi une étape de polissage mécano-chimique et une étape de nettoyage RCA qui permet de réduire l'influence de ces traitements sur l'apparition de défauts HF notamment lors de traitements ultérieurs et, par conséquent, de réduire la densité de défauts HF dans de telles couches.

Ce but est atteint avec un procédé de traitement d'une plaque comprenant au moins une couche superficielle en matériau semi-conducteur, la surface de ladite couche superficielle ayant subi une étape de polissage mécano-chimique suivie d'une étape de nettoyage RCA, procédé dans lequel, après l'étape de polissage et avant l'étape de nettoyage RCA, on réalise une étape de nettoyage intermédiaire de la surface de la couche superficielle en matériau semi-conducteur avec une solution de SC1 dans des conditions de concentration et de température permettant de réduire l'apparition ultérieure de défauts (défauts HF) en comparaison d'une même couche superficielle n'ayant pas subi ladite étape de nettoyage intermédiaire.

En effet, la Demanderesse a constaté, comme décrit plus loin en détail, que la densité de défauts HF apparaissant lors de traitements ultérieurs (ex. oxydation sacrificielle) est bien moins importante dans une couche superficielle ayant subi l'étape de nettoyage intermédiaire selon l'invention que dans une même couche n'ayant pas subi cette étape (i.e. ayant subi seulement l'étape de polissage et l'étape de nettoyage RCA). Sans cette étape de nettoyage intermédiaire, il y a formation de défauts dans la couche superficielle par gravure préférentielle au niveau des résidus ou contaminants de polissage. Ces défauts peuvent être des défauts débouchant en surface de la couche, ce sont alors déjà des défauts HF. Lorsque ces défauts ne sont pas débouchant, ils peuvent devenir des défauts débouchant et, par conséquent, des défauts HF, lors d'étapes de traitement ultérieures comme par exemple lors d'un amincissement par oxydation sacrificielle, qui peut transformer un défaut non débouchant en défaut débouchant, car l'amincissement est "conforme", c'est-à-dire que l'enlèvement de matière est constant sur la surface quelle que soit l'épaisseur initiale.

Selon un aspect de l'invention, la solution de SC1 comprend 1 volume d'hydroxyde d'ammonium (NH₄OH), 4 volumes de peroxyde d'hydrogène (H₂O₂) et entre 10 et 40 volumes d'eau dé-ionisée (H₂O), ladite solution de SC1 étant à une température inférieure à 50°C.

Par exemple, la solution de SC1 peut comprendre 1 volume d'hydroxyde d'ammonium (NH₄OH), 4 volumes de peroxyde d'hydrogène (H₂O₂) et 20 volumes d'eau dé-ionisée (H₂O) et être utilisée à une température de 20°C ± 5°C.

L'étape de nettoyage intermédiaire peut être réalisée par trempage de la plaque comportant la couche utile semi-conductrice dans un bain de solution de SC1.

Selon une variante de mise en oeuvre, l'étape de nettoyage est réalisée avec une installation de polissage comprenant une tête de polissage qui maintien la plaque, la surface de la couche superficielle en matériau semi-conducteur de la plaque étant également maintenue en contact avec un plateau, ladite installation de polissage comprenant un conduit d'injection par lequel la solution de SC1 est dispensée.

L'épaisseur de la couche superficielle en matériau semi-conducteur est de préférence inférieure à 1000 angströms.

La couche superficielle en matériau semi-conducteur peut être en silicium (Si) ou en silicium-germanium (SiGe) et constituer éventuellement la couche superficielle d'une structure respectivement SOI ou SGOI (structure de SiGe sur isolant) fabriquée suivant la technologie Smart Cut™ par exemple.

La présente invention concerne également une plaque comprenant au moins une couche superficielle en matériau semi-conducteur, ladite couche superficielle ayant une épaisseur inférieure à 1000 angströms, un niveau de rugosité inférieur à 2,5 angströms RMS pour une surface de balayage de 2*2 microns, et une densité de défauts HF inférieure à 0,5/cm², voire inférieure à 0,1/cm². La Plaque peut être une structure de silicium sur isolant (SOI).

### Brève description des figures

- la figure 1 représente schématiquement une installation de polissage utilisée pour réaliser l'étape de nettoyage intermédiaire selon l'invention,
- la figure 2 est un graphique montrant l'effet de l'étape de nettoyage intermédiaire de l'invention sur des couches de silicium de différentes épaisseurs.

### Exposé détaillé de modes de réalisation de l'invention

La présente invention a pour objectif de réduire la densité de défauts HF dans des structures finies comprenant au moins une couche utile superficielle en matériau semi-conducteur telle que par exemple une couche de silicium ou de silicium-germanium (SiGe) présentant une épaisseur inférieure à 1000 Å. On entend par structure "finie" une structure pour laquelle la surface de la couche utile semi-conductrice a subit au moins une étape de polissage mécano-chimiqe et une étape de nettoyage de la surface de la couche utile au moyen d'un traitement RCA comme décrit précédemment. Cette étape de polissage peut être également précédée ou suivie d'un traitement thermique de surface tel qu'une oxydation sacrificielle ou recuit thermique rapide ou lent.

La Demanderesse a observée que l'ajout d'une étape de nettoyage intermédiaire avec une solution de SC1 adoucie dans des conditions d'utilisation (concentration, température) qui sont décrites en détail plus loin, et ce entre l'étape de polissage mécano-chimiqe et l'étape de nettoyage RCA proprement dite, permet de réduire significativement la densité des défauts HF dans la structure finie.

Cette étape intermédiaire contribue à la suppression des contaminants et des défauts mineurs, éventuellement des résidus de polissage, produits lors de l'étape de polissage mécano-chimique notamment en raison de l'utilisation d'une suspension d'agent chimique avec particules abrasives (contamination métallique). Ces contaminants et petits défauts agissent comme des "catalyseurs" dans l'apparition des défauts HF lors de traitements ultérieurs. En effet, par exemple, ces contaminants et petits défauts semblent former des lieux préférentiels de gravure lors de l'étape de nettoyage de la surface de la couche utile semi-conductrice par traitement RCA et conduire à l'apparition de défauts. Ces défauts peuvent traverser la couche mince semi-conductrice et déboucher sur la couche enterrée (ex. couche d'oxyde) lors du traitement RCA (on parle alors de défauts HF car il peuvent être révélés) ou sont susceptibles de déboucher lors d'un traitement ultérieur, comme par exemple une oxydation sacrificielle.

Ainsi, en contrôlant (i.e. en réduisant) le degré d'attaque ("etching") de la solution de SC1 (solution de SC1 adoucie) utilisée pendant l'étape de nettoyage intermédiaire, il est possible, avant l'étape de nettoyage RCA standard, d'éliminer les contaminants et de passiver les défauts mineurs à partir desquels les défauts HF se développent, et ce sans attaquer la couche utile semi-conductrice.

Le contrôle du degré d'attaque de la solution de SC1 adoucie utilisée dans l'étape de nettoyage intermédiaire conforme à l'invention s'opère principalement par l'ajustement des concentrations des composants de la solution de SC1 et de la température de cette solution. En effet, l'étape de nettoyage intermédiaire selon l'invention doit permettre d'éliminer les contaminants et de passiver les défauts mineurs pour éviter l'apparition de défauts HF sans pour autant attaquer la couche utile semi-conductrice. Si les conditions d'utilisation de la solution de SC1 (i.e. concentrations des constituants et température) confèrent à cette dernière un degré d'attaque trop important, il y a un risque d'attaquer la couche utile trop en profondeur et d'engendrer des défauts supplémentaires dans la couche. En d'autres termes, la concentration en aditif de la solution de SC1 ainsi que sa température d'utilisation doivent être relativement réduites par rapport aux conditions d'utilisation habituelles des solutions de SC1 dans les nettoyages RCA mais jusqu'à une certaine limite en dessous de laquelle l'étape nettoyage intermédiaire ne produit plus assez d'effets (i.e. ne permet plus d'éliminer de façon significative les défauts mineurs et les contaminants ou résidus issus du polissage mécano-chimique). Au vu des exemples donnés ci-après, l'homme du métier sera à même d'ajuster les conditions de concentration et de température de la solution de SC1 lors de l'étape de nettoyage intermédiaire pour traiter la surface de la couche utile en matériau semi-conducteur.

De façon connue, une solution de SC1 contient de l'hydroxyde d'ammonium (NH₄OH), du peroxyde d'hydrogène (H₂O₂) et de l'eau dé-ionisée (H₂O). Conformément à l'invention la formulation de la solution de SC1 adoucie est la suivante :
- 1 volume d'hydroxyde d'ammonium (NH₄OH),
- 4 volumes de peroxyde d'hydrogène (H₂O₂), et
- entre 10 et 40 volumes d'eau dé-ionisée (H₂O).

La température d'utilisation de la solution de SC1 dans l'étape de nettoyage intermédiaire de l'invention ne doit pas excéder 50°C environ. La solution est de préférence utilisée à température ambiante, ce qui évite d'avoir recours à des moyens de chauffage et simplifie le contrôle de l'étape de nettoyage intermédiaire. De façon bien connue, l'augmentation de température de la solution entraîne l'augmentation de son degré d'attaque (activation).

A titre d'exemple, à température ambiante, admise à une valeur de référence de 20°C ± 5°C, une solution de SC1 adoucie contenant 1 volume de NH₄0H, 4 volumes de H₂O₂ et 20 volumes de H₂O offre une bonne capacité de réduction des défauts HF tout en minimisant l'attaque sur la couche de semi-conducteur. Toutefois, une solution de SC1 contenant 15 volumes de H₂O donne également de bons résultats tout comme une solution de SC1 contenant 30 volumes de H₂O à la température ambiante.

Par ailleurs, le temps nécessaire d'application de cette solution de SC1 adoucie est d'environ 1 minute.

Selon un premier mode de mise en oeuvre de l'invention, l'étape de nettoyage intermédiaire est réalisée par trempage de la plaque comportant la couche utile semi-conductrice dans un bain d'une solution de SC1 ayant la formulation décrite précédemment. Le bain contenant la solution de SC1 est de préférence à température ambiante et le temps de trempage est d'environ 1 minute.

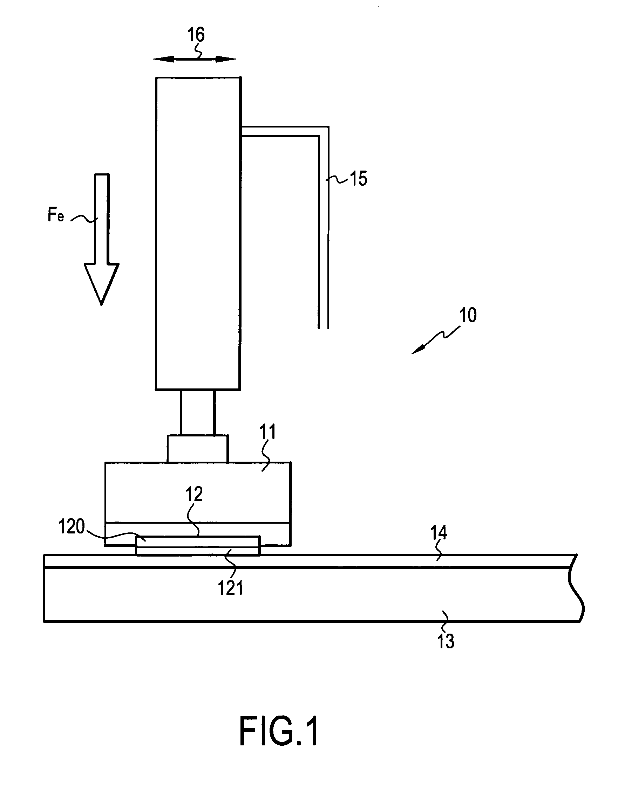

Selon un autre mode de réalisation de l'invention, on utilise une installation de polissage pour réaliser l'étape de nettoyage intermédiaire avec la solution de SC1 adoucie. La figure 1 représente une installation de polissage 10 qui comprend une tête de polissage 11 dans laquelle est insérée un substrat comme par exemple un substrat SOI 12 comprenant un support isolant 120 et une couche de silicium 121 en tant que couche utile semi-conductrice. L'installation 10 comprend en outre un plateau 13 et un tissu 14 de polissage. Conformément à l'invention, on utilise un conduit 15, habituellement destiné à dispenser la suspension abrasive dans la tête, pour répandre la solution de SC1 adoucie. Une pression Fe et un mouvement symbolisé par la flèche 16 sont appliqués à la tête pour assurer la mise en contact de toute la surface de la couche de silicium 121 avec la solution de SC1 adoucie.

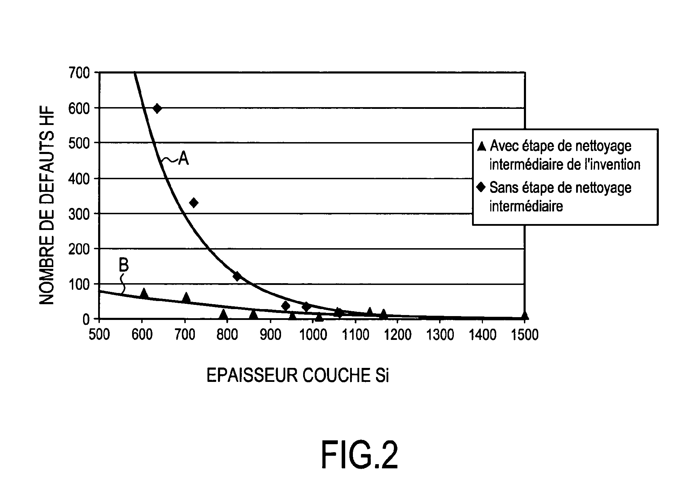

La figure 2 montre les résultats obtenus en matière de réduction des défauts HF dans des couches de silicium lorsqu'on met en oeuvre l'étape de nettoyage intermédiaire au moyen de la solution de SC1 adoucie selon l'invention comme par exemple une solution de SC1 adoucie contenant 1 volume de NH₄OH, 4 volumes de H₂O₂ et 20 volumes de H₂O à température ambiante.

Sur la figure 2, les courbes A et B représentent le nombre de défauts HF sur une plaque de 200mm, soit sur une surface de 314 cm², observés sur des couches de silicium ayant subi un polissage mécano-chimique et un nettoyage RCA, respectivement sans étape de nettoyage intermédiaire avec la solution SC1 adoucie (courbe A) et avec étape de nettoyage intermédiaire avec la solution SC1 adoucie (courbe B). On observe que la densité de défauts HF est liée à l'épaisseur de la couche de silicium, les courbes A et B montrant des résultats où les défauts HF ont été révélés après amincissement jusqu'à des épaisseurs de couches de silicium dont la valeur est indiquée en abscisse. Cette observation permet d'établir que les défauts HF observés dans les plaques traitées suivant la méthode de l'art antérieur (i.e. polissage mécano-chimique directement suivi du traitement RCA standard sans étape de nettoyage intermédiaire), résultent de la présence de défauts non débouchant dans la couche plus épaisse. Ces défauts sont transformés en défauts HF lors de l'amincissement de la couche.

Comme on peut le constater sur la figure 2, la densité de défauts HF dans les couches de silicium est considérablement réduite lorsqu'on réalise une étape de nettoyage supplémentaire conforme à l'invention (cf. courbe B) par rapport à des mêmes couches n'ayant pas subit de nettoyage intermédiaire (cf. courbe A). L'impact de l'étape de nettoyage intermédiaire sur la réduction de densité de défauts HF devient significatif pour des couches présentant une épaisseur inférieure à 1000 Å avec un effet de plus en plus important à mesure que l'épaisseur diminue.

L'étape de nettoyage intermédiaire conforme à l'invention telle que décrite précédemment permet minimiser la défectivité dans une couche de matériau semi-conducteur ayant subit une étape de polissage mécano-chimique suivie d'une étape de nettoyage RCA. La présente invention s'applique, par conséquent, à des plaques de matériaux semiconducteurs seuls (ex. silicium ou silicium-germanium) ou bien à des plaques multicouches dont la couche superficielle est une couche en matériau semi-conducteur.

L'étape de nettoyage intermédiaire conforme à l'invention telle que décrite précédemment permet notamment de diminuer significativement la densité de défauts HF dans des structures SOI (ou SGOI) comprenant typiquement une couche superficielle en matériau semi-conducteur, comme du silicium (ou un alliage silicium-germanium), ayant une épaisseur inférieure à 1000 Å et qui sont fabriquées suivant la technologie Smart Cut™, c'est-à-dire par transfert (après implantation et clivage) d'une couche fine de matériau semi-conducteur sur un support isolant nécessitant des étapes de polissage mécano-chimique et de nettoyage RCA de la surface de la couche de semi-conducteur transférée.

## Revendications

1. Procédé de traitement d'une plaque (12) comprenant au moins une couche superficielle (121) en matériau semi-conducteur, la surface de ladite couche superficielle ayant subit une étape de polissage mécano-chimique suivie d'une étape de nettoyage RCA, **caractérisé en ce qu'**il comprend, après l'étape de polissage et avant l'étape de nettoyage RCA, une étape de nettoyage intermédiaire de la surface de la couche superficielle en matériau semi-conducteur avec une solution de SC1 dans des conditions de concentration et de température permettant de réduire l'apparition de défauts dans la couche superficielle par rapport à une même couche superficielle n'ayant pas subi ladite étape de nettoyage intermédiaire.

2. Procédé selon la revendication 1, **caractérisé en ce que** la solution de SC1 comprend 1 volume d'hydroxyde d'ammonium (NH₄OH), 4 volumes de peroxyde d'hydrogène (H₂O₂) et 10 volumes d'eau dé-ionisée (H₂O), ladite solution de SC1 étant à une température ambiante.

3. Procédé selon la revendication 1, **caractérisé en ce que** la solution de SC1 comprend 1 volume d'hydroxyde d'ammonium (NH₄OH), 4 volumes de peroxyde d'hydrogène (H₂O₂) et 40 volumes d'eau dé-ionisée (H₂O), ladite solution de SC1 étant à une température ambiante.

4. Procédé selon la revendication 1, **caractérisé en ce que** la solution de SC1 comprend 1 volume d'hydroxyde d'ammonium (NH₄OH), 4 volumes de peroxyde d'hydrogène (H₂O₂) et 20 volumes d'eau dé-ionisée (H₂O), ladite solution de SC1 étant à une température de 20°C ± 5°C.

5. Procédé selon l'une quelconque des revendications 1 à 4, **caractérisé en ce que** l'étape de nettoyage intermédiaire est mise en oeuvre pendant 1 minute environ.

6. Procédé selon l'une quelconque des revendications 1 à 5, **caractérisé en ce que** l'étape de nettoyage intermédiaire est réalisée par trempage de la plaque comportant la couche utile semi-conductrice dans un bain de solution de SC1.

7. Procédé selon l'une quelconque des revendications 1 à 5, **caractérisé en ce que** l'étape de nettoyage est réalisée avec une installation de polissage (10) comprenant une tête de polissage maintenant la plaque (12), la surface de la couche superficielle en matériau semi-conducteur (121) de la plaque étant également maintenue en contact avec un plateau, ladite installation de polissage comprenant un conduit d'injection (15) par lequel la solution de SC1 est dispensée.

8. Procédé selon l'une quelconque des revendications 1 à 7, **caractérisé en ce que** l'épaisseur de la couche superficielle en matériau semi-conducteur est inférieure à 1000 angströms.

9. Procédé selon l'une quelconque des revendications 1 à 8, **caractérisé en ce que** la couche superficielle en matériau semi-conducteur est en silicium (Si).

10. Procédé selon la revendication 9, **caractérisé en ce que** la plaque est une structure de silicium sur isolant (SOI) fabriquée selon la technologie Smart Cut™.

11. Procédé selon l'une quelconque des revendications 1 à 8, **caractérisé en ce que** la couche superficielle en matériau semi-conducteur est en silicium-germanium (SiGe).

12. Procédé selon la revendication 11, **caractérisé en ce que** la plaque est une structure de silicium-germanium sur isolant (SGOI) fabriquée selon la technologie Smart Cut™.

13. Plaque comprenant au moins une couche superficielle en matériau semi-conducteur traitée conformément au procédé selon l'une quelconque des revendications 1 à 12, ladite couche superficielle ayant une épaisseur inférieure à 1000 angströms, un niveau de rugosité inférieur à 2,5 angströms RMS pour une surface de balayage de 2*2 microns, et une densité de défauts HF inférieure à 0,5/cm².

14. Plaque selon la revendication 13, **caractérisée en ce qu'**elle comprend une structure de silicium sur isolant (SOI).

15. Plaque selon la revendication 13 ou 14, **caractérisée en ce qu'**elle présente une densité de défauts HF inférieure à 0,1/cm².
